# EUROPEAN PATENT SPECIFICATION

(11) **EP 1 619 795 B1**
(45) Date of publication and mention of the grant of the patent: **19.03.2008**
(21) Application number: 05015647.0
(22) Date of filing: 19.07.2005
(51) Int. Cl.: H03H 17/06

(54) **Ripple elimination filter**
Filter zur Eliminierung der Überschwingungen
Filtre pour éliminer des suroscillations

(30) Priority: 20.07.2004 US 893900
(43) Date of publication of application: 25.01.2006
(73) Proprietor: LDS Test and Measurement Inc., 06492 Yalesville CT (US)
(72) Inventor: Shen, Guozhong, 94538 Fremont CA (US); Zhuge, James, 94301 Palo Alto CA (US)
(74) Representative: Lang, Friedrich

(56) References cited:
- DE-A1- 3 630 299
- US-A1- 2003 235 248
- SMITH S W: "The Scientist and Engineer's Guide to Digital Signal Processing" -, 1997, pages 277-284, XP002131786
- KEN C. POHLMANN: "Principles of Digital Audio" 2000, MCGRAW-HILL , USA , XP002352915 * page 64 - page 66; figure 3.12 *

## Description

### FIELD OF THE INVENTION

The present invention relates generally to filters. More particularly, the present invention relates to ripple elimination filters.

### BACKGROUND OF THE INVENTION

There can be significant differences in a signal when working in the frequency domain versus the time domain. Techniques have been developed for digital signal analysis (DSA) to adapt the cut off frequency with the sampling rate. Although these techniques work well for DSA applications, they do not produce adequate results for data acquisition (DAQ) applications. Accordingly, it is desirable to provide a way to produce adequate results for DAQ applications.

State of the art showing examples of said techniques is disclosed in professional articles (see SMITHS S W: "The Scientist and Engineer's Guide to Digital Signal Processing", 1997, pages 277-284, XP002131786; and KEN C. POHLMANN: "Principles of Digital Audio" 2000, MCGRAW-HILL, USA, XP002352915) and documents DE 36 30 299 A1 and US 2003/235248 A1.

### SUMMARY OF THE INVENTION

The foregoing needs are met, to a great extent, by the present invention including a method 1 according to claim 1 and a device according to claim 3 that in some embodiments reduce or eliminate a ripple in a signal.

In accordance with one embodiment of the invention a method for converting an analog signal into a digital signal without a step response sipple includes receiving an analog signal; converting the analog signal into a digital signal by an A/D converter; passing the digital signal through a low pass filter and a decimation filter forming a resultant digital signal; and filtering the resultant digital signal with a Finite Impulse Response (FIR) filter having a number of taps between 2 and 10, wherein when half a sampling frequency of the resultant digital signal is normalized as 1, the FIR has a transition bandwidth greater than or equal to .1 of the normalized frequency, resulting in a digital signal without a step response ripple.

The resultant signal in some embodiments of the invention is filtered through a 4-tap Finite Impulse Response filter (FIR).

In another embodiment of the invention, a device for converting an analog signal into a digital signal without step response ripple includes an input that receives an analog signal; an A/D converter in communication with said input and converting the analog signal into a digital signal; a low pass filter in communication with said A/D converter and filtering the digital signal; a decimation filter in communication with the low pass filter, receiving the filtered digital signal and outputting a resultant signal; and a Finite Impulse Response (FIR) filter having a number of taps between 2 and 10, being in communication with said decimation filter and receiving the resultant digital signal, wherein when half a sampling frequency of the resultant digital signal is normalized as 1, the FIR has a transition bandwidth greater than or equal to 1 of the normalized frequency, resulting in a signal without a step response ripple.

The filter in other embodiments of the invention is a 4-tap Finite Impulse Response filter (FIR).

### BRIEF DESCRIPTION OF THE DRAWING

FIG.1 is a block diagram of the present invention.

FIG. 2 is a graph illustrating a signal having a ripple.

FIG. 3 is a is a graph illustrating a response for a 4-tap FIR ripple elimination filter.

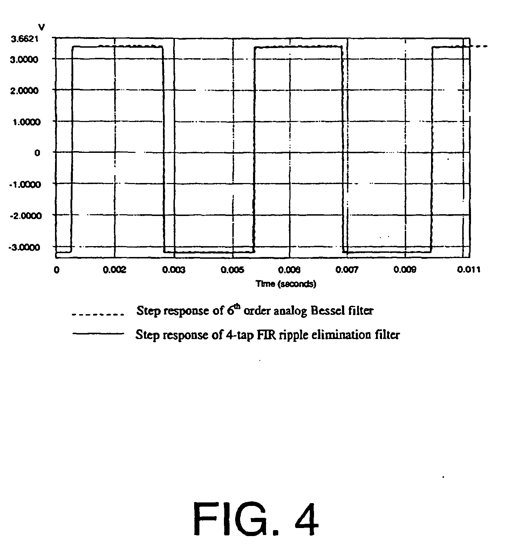

FIG. 4 is a graph illustrating a step response for a 4-tap FIR and a 6^{th} order analog Bessel filter.

FIG. 5 is a graph illustrating a step response.

FIG. 6 is a graph illustrating a ramp up comparison between a step response of a ripple elimination filter and a 6^{th} order analog Bessel filter..

### DETAILED DESCRIPTION

The invention will now be described with reference to the drawing figures, in which like reference numerals refer to like parts throughout. An embodiment in accordance with the present invention provides a method for producing adequate results in data acquisition (DAQ) applications by removing a step response ripple from a signal using a filter having a linear phase and a slow transition band. Another embodiment in accordance with the present invention provides a device that removes a step response ripple from a signal using a filter having a linear phase and a slow transition band.

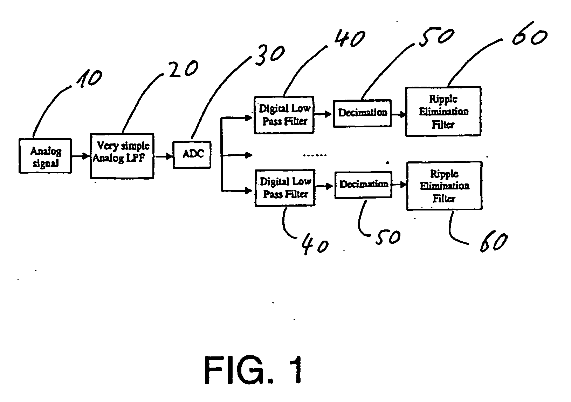

An embodiment of the present inventive apparatus is illustrated in FIG. 1. An analog signal 10 is passed through an analog low pass filter (LPF) 20. The signal is then converted by A/D Converter (ADC) 30 into a digital signal. The digital signal is passed through a digital low pass filter 40 then through a decimation filter 50. The resultant signal from decimation 50 is then passed through ripple elimination filter 60.

For DAQ applications an anti-aliasing filter can be used before the signal is converted from analog to digital. The example depicted in FIG. 1 uses an LPF 20 as an anti-aliasing filter. If LPF 20 is fixed at a relatively high frequency, the phase distortion by capacitor error will be decreased and thereby improve the channel phase match. Since the sampling rate can vary greatly in range, the cut off frequency should adapted accordingly.

It is very difficult and sometimes even impossible to adapt the cut off frequency of an analog filter when the filter order is high. Digital decimation is often used to vary the sampling rate and thus the hardware sampling rate is fixed at a relatively high number and the cut off frequency of the analog filter does not need to adapt.

The use of decimation filter 50 is good enough for DSA applications, where people pay more attention to the frequency domain property of the signal. However for DAQ applications where people emphasize the time domain property, a sharp decimation filter creates a step response having significant overshoot.

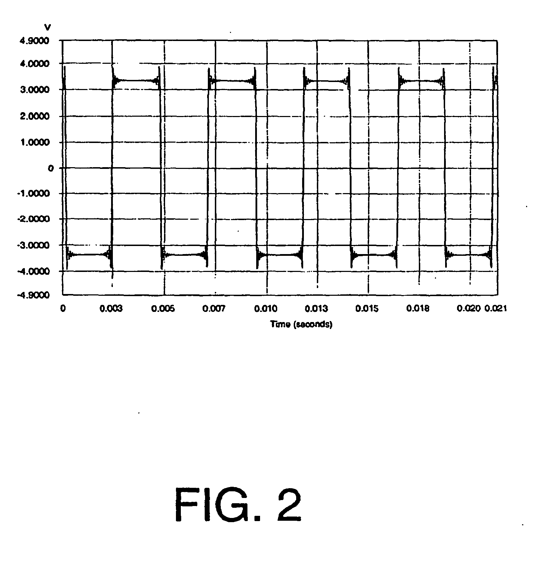

As shown in FIG. 2, the overshoot creates a ripple that can go easily as high as 10% of the step. This ripple is unacceptable for some DAQ applications. A Bessel filter will generate one of the best step responses in the analog domain. This, however, is not true in the digital domain. We have found two key points that are needed to generate a suitable step response in the time domain. The first key point is to have a constant group delay or linear phase, and the second key point is to have a slow transition band.

In order to accomplish these goals, one could use a digital Bessel filter, but the result is not as good as an analog Bessel filter. The reason is that when an analog filter is translated into digital, a tangent transform is used to transform the digital frequency to analog frequency, since the tangent transform is a non-linear transform. Thus there is a loss of linear phase, which is one of the key properties of analog Bessel filter.

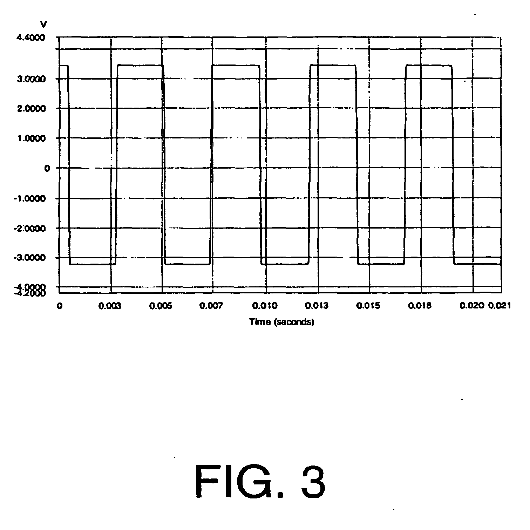

Another solution would be to use a ripple elimination filter having a linear phase. Obtaining a linear phase can be accomplished by using a Finite Impulse Response filter (FIR). A FIR normally has a very sharp transition band, which is a really good feature in the frequency domain, but a nightmare to work with in the time domain. However, if the transition band is slow better results may be realized. A FIR with a few taps can have a slow transition band. It has been determined that in some instance a FIR having between 2 to 10 taps will perform well. FIG. 3 gives the step response with a 4-tap FIR ripple elimination filter, which shows no overshoot. The result is as good as analog Bessel filter, as shown in FTG. 4 which is a comparison between the step response of 4-tap FIR (solid line) and a step response of a 6^{th} order analog Bessel filter (dotted line).

If half of the sampling frequency is normalized as "1", for a digital filter, its frequency response graph will have from 0 to 1 as its frequency axis. In some cases a sharp transition band covers anything smaller than 0.1 of the normalized frequency. A slow transition band can then be defined in some instances as a transition band which covers at least 0.1 of the normalized frequency.

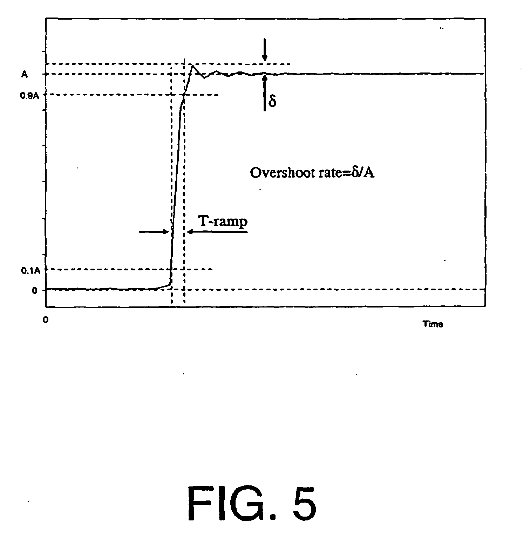

A further analysis comparing a step response of a 4-tap FIR and a step response of an analog Bessel filter can be done by comparing overshoot rate and ramp up speed. Ramp up speed depicted in FIG. 5 as T-ramp can be defined as the time it takes to go from 0.1A to 0.9A. Overshoot rate depicted in FIG. 5 is defined as δ/A.

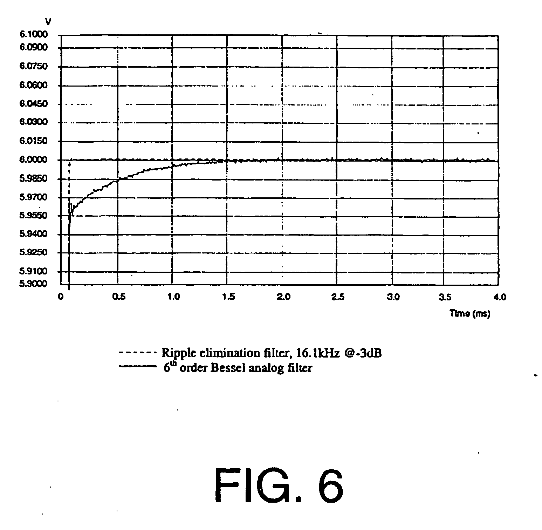

FIG. 6 is a ramp up comparison between a step response of a ripple elimination filter and a 6^{th} order analog Bessel filter. The ramp up sequence for the analog Bessel filter can be separated into two steps. The first step ramps up quickly to about 99% of the step. The second step ramp up goes slowly from 99% to 100%. There are some ripples in the transition between the two steps. It can be calculated from FIG. 6 that the maximum error caused by the analog Bessel filter is about .91%, which can be used as the overshoot equivalence value.

An advantage of anti-aliasing with a ripple elimination filter as depicted in FIG. 1 is that overcomes shortcomings of a Sigma-Delta AD converter and a poor step response. A smooth path is created for the Sigma-Delta AD converter entering data acquisition applications, so DAQ and DSA can more easily share the same hardware. As the Sigma-Delta AD converter is used there will be a better phase match between channels, a wider bandwidth with the same sampling rate, cost savings, less space used on a printed circuit board (PCB) and more versatility.

There is better phase match between channels because the analog filter is fixed at a relatively high frequency. The phase distortion by capacitor error will therefore be decreased, thus improving the channel phase match

There is a wider bandwidth with same sampling rate since when the frequency domain property is emphasized, the cut off frequency of decimation filter can be set at or near 0.45Fs.

The implementation will be cheaper and there will be PCB space savings since the use of a high order analog filter will not be necessary, which not only saves money, but also saves PCB space, thus makes the instrument even smaller.

The implementation will be more versatile since a powerful digital filter can be applied after sampling according to different application needs.

The many features and advantages of the invention are apparent from the detailed specification, and thus, it is intended by the appended claims to cover all such features and advantages of the invention which fall within the true spirit and scope of the invention. Further, since numerous modifications and variations will readily occur to those skilled in the art, it is not desired to limit the invention to the exact construction and operation illustrated and described, and accordingly, all suitable modifications and equivalents may be resorted to, falling within the scope of the invention.

## Claims

1. A method for converting an analog signal (10) into a digital signal without a step response ripple comprising:
receiving an analog signal (10);
converting the analog signal (10) into a digital signal by a A/D Converter (30);
passing the digital signal through a low pass filter (40) and a decimation filter (50) forming a resultant digital signal;
**characterized in that**
said method further comprising the step of
filtering the resultant digital signal with a Finite Impulse Response filter FIR having a number of taps between 2 and 10,
wherein when half a sampling frequency of the resultant digital signal is normalized as 1, the FIR has a transition bandwidth greater than or equal to .1 of the normalized frequency, resulting in a digital signal without a step response ripple.

2. The method as recited in claim 1, wherein the resultant signal is filtered through a 4-tap Finite Impulse Response filter FIR.

3. A device for converting an analog signal (10) into a digital signal without a step response ripple comprising:
an input that receives an analog signal (10);
a A/D Converter (30) in communication with said input and converting the analog signal (10) into a digital signal;
a low pass filter (40) in communication with said A/D-Converter (30) and filtering the digital signal;
a decimation filter (50) in communication with said low pass filter (40), receiving the filtered digital signal and outputing a resultant digital signal;
**characterized in that**
said device further comprising
a Finite Impulse Response filter FIR having a number of taps between 2 and 10, being in communication with said decimation filter and receiving the resultant digital signal, wherein when half a sampling frequency of the resultant digital signal is normalized as 1, the FIR has a transition bandwith greater than or equal to .1 of the normalized frequency, resulting in a digital signal without a step response ripple.

4. The device as recited in claim 3, wherein said filter is a 4-tap Finite Impulse Response filter FIR.

## Patentansprüche

1. Verfahren zum Umwandeln eines Analogsignals (10) in ein Digitalsignal ohne Sprungantwort-Welligkeit, umfassend:
den Empfang eines Analogsignals (10);
die Umwandlung des Analogsignals (10) in ein Digitalsignal durch einen A/D-Wandler (30);
das Senden des Digitalsignals durch ein Tiefpassfilter (40) und ein Dezimationsfilter (50), wodurch ein resultierendes Digitalsignal gebildet wird;
**dadurch gekennzeichnet, dass**
das Verfahren darüber hinaus folgenden Schritt umfasst:
die Filterung des resultierenden Digitalsignals mittels eines Filters mit endlicher Impulsantwort FIR, das eine Anzahl von Anzapfungen zwischen 2 und 10 aufweist, wobei, wenn eine halbe Abtastfrequenz des resultierenden Digitalsignals auf 1 normiert ist, das FIR eine Durchlassbandbreite aufweist, die größer als oder gleich 0,1 der normierten Frequenz ist, was zu einem Digitalsignal ohne Sprungantwort-Welligkeit führt.

2. Verfahren nach Anspruch 1, wobei das resultierende Signal durch ein Filter mit endlicher Impulsantwort FIR mit 4 Anzapfungen gefiltert wird.

3. Vorrichtung zum Umwandeln eines Analogsignals (10) in ein Digitalsignal ohne Sprungantwort-Welligkeit, umfassend:
einen Eingang, der ein Analogsignal (10) empfängt;
einen A/D-Wandler (30), der mit dem Eingang in Verbindung steht und das Analogsignal (10) in ein Digitalsignal umwandelt;
ein Tiefpassfilter (40), das mit dem A/D-Wandler (30) in Verbindung steht und das Digitalsignal filtert;
ein Dezimationsfilter (50), das mit dem Tiefpassfilter (40) in Verbindung steht, das gefilterte Digitalsignal empfängt und ein resultierendes Digitalsignal ausgibt;
**dadurch gekennzeichnet, dass**
die Vorrichtung darüber hinaus Folgendes umfasst:
ein Filter mit endlicher Impulsantwort FIR, das eine Anzahl von Anzapfungen zwischen 2 und 10 aufweist, mit dem Dezimationsfilter in Verbindung steht und das resultierende Digitalsignal empfängt, wobei, wenn eine halbe Abtastfrequenz des resultierenden Digitalsignals auf 1 normiert ist, das FIR eine Durchlassbandbreite aufweist, die größer als oder gleich 0,1 der normierten Frequenz ist, was zu einem Digitalsignal ohne Sprungantwort-Welligkeit führt.

4. Vorrichtung nach Anspruch 3, wobei das Filter ein Filter mit endlicher Impulsantwort FIR mit 4 Anzapfungen ist.

## Revendications

1. Procédé pour convertir un signal analogique (10) en signal numérique sans ondulation de la réponse transitoire, comprenant :
la réception d'un signal analogique (10) ;
la conversion du signal analogique (10) en signal numérique par un convertisseur A/N (30) ; le passage du signal numérique à travers un filtre passe-bas (40) et un filtre de décimation (50) pour former un signal numérique résultant ;
**caractérisé en ce que** ledit procédé comprend en outre l'étape de filtrage du signal numérique résultant avec un filtre à réponse impulsionnelle finie FIR ayant un nombre de prises compris entre 2 et 10,
dans lequel, lorsque la moitié de la fréquence d'échantillonnage du signal numérique résultant est normalisée à 1, le FIR a une bande passante de transition supérieure ou égale à 0,1 de la fréquence normalisée, ce qui a pour résultat un signal numérique sans ondulation de réponse transitoire.

2. Procédé selon la revendication 1, dans lequel le signal résultant est filtré à travers un filtre à réponse impulsionnelle finie FIR à 4 prises.

3. Dispositif pour convertir un signal analogique (10) en signal numérique sans ondulation de réponse transitoire, comprenant :
une entrée qui reçoit un signal analogique (10) ;
un convertisseur A/N (30) qui communique avec ladite entrée et convertit le signal analogique (10) en signal numérique ;
un filtre passe-bas (40) qui communique avec ledit convertisseur A/N (30) et filtre le signal numérique ;
un filtre de décimation (50) qui communique avec ledit filtre passe-bas (40), recevant le signal numérique filtrée et produisant en sortie un signal numérique résultant ;
**caractérisé en ce que** ledit dispositif comprend en outre un filtre à réponse impulsionnelle finies FIR ayant un nombre de prises compris entre 2 et 10, qui communique avec ledit filtre de décimation et reçoit le signal numérique résultant,
dans lequel, lorsque la moitié d'une fréquence d'échantillonnage du signal numérique résultant est normalisée à 1, le FIR a une bande passante de transition supérieure ou égale à 0,1 de la fréquence normalisée, ce qui a pour résultat un signal numérique sans ondulation de réponse transitoire.

4. Dispositif selon la revendication 3, dans lequel ledit filtre est un filtre à réponse impulsionnelle finie FIR à 4 prises.
